# EUROPEAN PATENT APPLICATION

(11) **EP 4 321 658 A1**
(43) Date of publication of application: **14.02.2024**
(21) Application number: 22784449.5
(22) Date of filing: 16.03.2022
(51) Int. Cl.: C30B 25/18, H01L 21/205, C30B 29/38

(54) **METHOD FOR PRODUCING NITRIDE SEMICONDUCTOR WAFER**

(30) Priority: 08.04.2021 JP 2021066022
(71) Applicant: Shin-Etsu Handotai Co., Ltd., Tokyo 100-0004 (JP)
(72) Inventor: HAGIMOTO, Kazunori, Annaka-shi, Gunma 379-0196 (JP); ISHIZAKI, Junya, Annaka-shi, Gunma 379-0196 (JP); OHTSUKI, Tsuyoshi, Annaka-shi, Gunma 379-0196 (JP)
(74) Representative: Sonnenhauser, Thomas Martin
(86) International application number: PCT/JP2022/011764
(87) International publication number: WO 2022/215464

(57) **Abstract**

The present invention relates to a method for producing a nitride semiconductor wafer by forming a nitride semiconductor film on a silicon single-crystal substrate, including the steps of forming the nitride semiconductor film on the silicon single-crystal substrate and irradiating the silicon single-crystal substrate with electron beams with an irradiation dose of 1×10¹⁴/cm² or more. Thus, provided is a method for producing a nitride semiconductor wafer in which a nitride semiconductor film is formed on a silicon single-crystal substrate, and in which a loss and a second harmonic characteristic due to the substrate are improved.

## Description

### TECHNICAL FIELD

The present invention relates to a method for producing a nitride semiconductor wafer, and particularly, a method for producing a nitride semiconductor wafer suitable for use for a high-frequency device.

### BACKGROUND ART

High-frequency devices are being developed to integrate devices such as antennas, amplifiers, switches, and filters in order to reduce size and cost. As frequencies become higher, circuits become more complex, and the materials used in devices also become more diverse, including silicon CMOS, devices using group III-V semiconductors and nitride semiconductors, and filters using piezoelectric substances.

A silicon single-crystal substrate, which is inexpensive and available in a large-diameter wafer, is considered suitable as a base substrate for these devices.

### CITATION LIST

### PATENT LITERATURE

Patent Document 1: WO2005/020320A1

### SUMMARY OF INVENTION

### TECHNICAL PROBLEM

However, in conventional high-frequency devices above-described, characteristic degradations due to substrates, losses and degradations in a second harmonic characteristic and a third harmonic characteristic due to substrates are observed.

Here, a harmonic is a frequency component of a higher order that is an integral multiple of an original frequency. When the original frequency is defined as a fundamental, the second harmonic is defined as a frequency at twice the fundamental (one-half of a wavelength), and the third harmonic is defined as a frequency at three times the fundamental (one-third of a wavelength). In a high-frequency circuit, a substrate with a small harmonic is required to avoid interference due to the harmonic.

Patent document 1 discloses an improvement of a switching characteristic by irradiating in advance toward a wide-gap bipolar semiconductor (SiC) for a power application with one of γ-ray, electron beams, or charged particle beams to adjust a carrier lifetime to a predetermined range, however, the Patent document 1 does not mention such as the degradation of a second harmonic characteristic.

The present invention has been made in view of the above-described problem. An object of the present invention is to provide a method for producing a nitride semiconductor wafer in which a nitride semiconductor film is formed on a silicon single-crystal substrate, and in which a loss and a second harmonic characteristic due to the substrate are improved.

### SOLUTION TO PROBLEM

To achieve the object, the present invention provides a method for producing a nitride semiconductor wafer by forming a nitride semiconductor film on a silicon single-crystal substrate, comprising the steps of:
forming the nitride semiconductor film on the silicon single-crystal substrate; and
irradiating the silicon single-crystal substrate with electron beams with an irradiation dose of 1×10¹⁴/cm² or more.

In such a method for producing the nitride semiconductor wafer, in which the irradiation of the electron beams with the irradiation dose (dose amount) of 1×10¹⁴/cm² or more, enables to produce a nitride semiconductor wafer in which a loss due to the substrate is improved and in which degradation of a second harmonic characteristic is suppressed by improving the second harmonic characteristic. Then, by applying the produced nitride semiconductor wafer especially to a high-frequency device, providing a high-frequency device of a high-quality having an improved loss (e.g., a power loss) and a second harmonic characteristic due to the substrate is enabled.

In these circumstances, in the step of irradiating the electron beams, the irradiation dose of the electron beams irradiated can be 3×10¹⁴/cm² or more and 1×10¹⁶/cm² or less.

Consequently, when the irradiation dose of the electron beams is 3×10¹⁴/cm² or more, the production of the nitride semiconductor wafer with a further-improved loss and further-suppressed degradation of the second harmonic characteristic is enabled. Additionally, the time required for the irradiation is not too long by setting the irradiation dose to 1×10¹⁶/cm² or less, and this makes this process efficient.

On the other hand, the step of irradiating the electron beams can be performed before the step of forming the nitride semiconductor film. Alternatively, the step of irradiating the electron beams can be performed after the step of forming the nitride semiconductor film.

In this manner, it is sufficient only to irradiate the electron beams of the irradiation dose above-described onto the silicon single-crystal substrate. The electron beams irradiation itself can be performed before or after the step for forming the nitride semiconductor film.

In this case, a device can be further formed in the nitride semiconductor film after the step of forming the nitride semiconductor film, and the step of irradiating the electron beams can be then performed.

Thus, the irradiation of the electron beams above-described can be performed after forming the device in the nitride semiconductor film.

### ADVANTAGEOUS EFFECTS OF INVENTION

The method of the present invention for producing the nitride semiconductor wafer can produce the nitride semiconductor wafer having the improved loss and the improved second harmonic characteristic due to the substrate, particularly, this method can provide the wafer suitable for the high-frequency device.

### BRIEF DESCRIPTION OF DRAWINGS

FIG. 1 is a schematic view illustrating an example of a nitride semiconductor wafer of the present invention.
FIG. 2 is a schematic plan view of a Co-Planar Waveguide (CPW) used for evaluating a second harmonic characteristic.
FIG. 3 is a graph showing second harmonic characteristics of substrates with different resistivities.

### DESCRIPTION OF EMBODIMENTS

As above-described, regarding a nitride semiconductor wafer in which a nitride semiconductor film is formed on a silicon single-crystal substrate, a producing method is desired, in which the method can obtain the nitride semiconductor wafer having an improved and upgraded loss and second harmonic characteristic with a suppressed degradation of characteristics.

To solve the above problem, the present inventors have earnestly studied and found a method for producing a nitride semiconductor wafer by forming a nitride semiconductor film on a silicon single-crystal substrate, comprising the steps of forming the nitride semiconductor film on the silicon single-crystal substrate, and irradiating the silicon single-crystal substrate with electron beams with an irradiation dose of 1×10¹⁴/cm² or more, consequently, also found that it is possible to produce a nitride semiconductor wafer having the improved and upgraded loss and second harmonic characteristic, and the suppressed degradation of the second harmonic characteristic. This finding has led to the completion of the present invention.

Hereinafter, embodiments of the present invention will be described in detail. However, the present invention is not limited thereto.

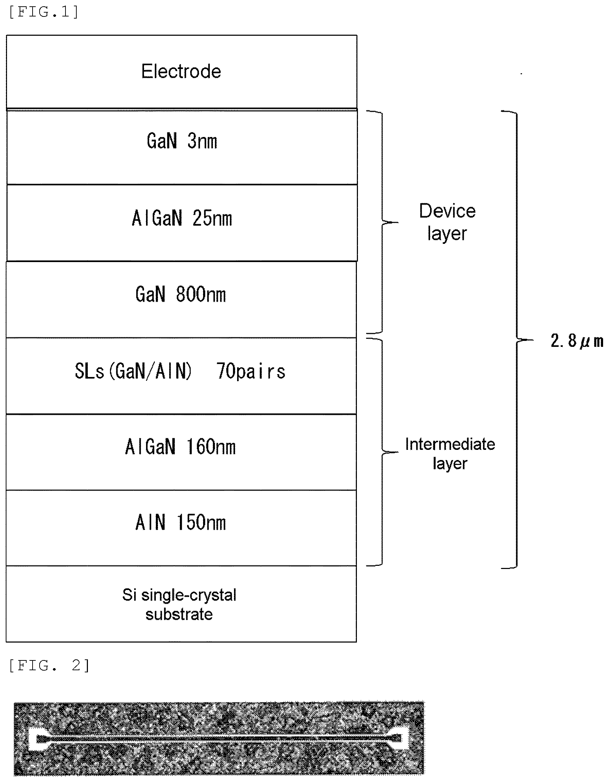

A method for producing a nitride semiconductor wafer is described with reference to FIG. 1.

In addition, a structure of the nitride semiconductor wafer described below is an example and is not limited thereto.

Firstly, a silicon single-crystal substrate is prepared. This silicon single-crystal substrate is not particularly limited, regarding a resistivity, for example, a high resistivity of 100 Qcm or more can be used. An upper limit of the resistivity is not particularly limited but can be 10000 Qcm or less. Also, the one of an ordinary resistance having a resistivity from 1 Qcm or more to less than 100 Qcm, or the one of a low resistance having a resistivity less than 1 Qcm can be used. In the method of the present invention, an improvement of the loss or the second harmonic characteristic above-described can be achieved regardless of the high or low resistivity of the silicon single-crystal substrate.

Incidentally, the producing method of the present invention includes the steps of forming a nitride semiconductor film on the silicon single-crystal substrate and irradiating the silicon single-crystal substrate with electron beams with a predetermined irradiation dose (1×10¹⁴/cm² or more). In the following steps, either step can be performed first, but it is preferable to perform the electron beams irradiation step later.

Then, the electron beam irradiation is performed on the silicon single-crystal substrate in the first place. By irradiating the electron beams, an effect by inactivating a dopant and/or a carrier such as a raw material-derived impurity in the silicon single-crystal substrate can be obtained remarkably. The inactivation here is due to the reaction of point defects with the dopant and/or the carrier, in other words, point defects are formed in the silicon single-crystal substrate by irradiating the electron beams, and these defects trap carriers in the silicon single-crystal substrate. Additionally, it is considered that the resistance is changeable by a decreased mobility of the dopant and/or the carrier due to the point defects. Furthermore, it is considered that as a result of the inactivation of the dopant and/or the carrier in the silicon single-crystal substrate, the silicon single-crystal substrate has high resistivity.

Moreover, as described later, it is considered that when the electron beams are irradiated after the step for forming the nitride semiconductor film, in addition to the effect above-described, the point defects in the nitride semiconductor film decrease, then the characteristics improve.

Then, in order to obtain the above effect, the irradiation dose of the electron beams should be 1×10¹⁴/cm² or more as the irradiation condition of the electron beams. Such irradiation dose enables the production of the nitride semiconductor wafer in which the loss and the second harmonic characteristic due to the substrate are improved after the formation of the nitride semiconductor film described later.

In this case, the irradiation dose of 3×10¹⁴/cm² or more is more preferably used, and the loss and the second harmonic characteristic can be further improved. Moreover, the irradiation dose of 1×10¹⁵/cm² or more is even more preferable.

On the other hand, the upper limit can be set to such as 1×10¹⁶/cm² or less. Such irradiation dose is efficient because it can prevent irradiation time from becoming too long than necessary.

Other conditions for irradiation are not limited, for example, an electron with energy of 250 keV or more can be used. When the irradiation of approximately 250 keV or more is performed, it is possible to form point defects in the silicon single-crystal substrate and inactivate the dopant and/or the carrier such as impurities due to raw materials in the silicon single-crystal substrate with more certain. Meanwhile, the upper limit of the irradiation energy is of no matter.

Shown here is an example, the electron beam irradiation is set to 2 MeV, 1×10¹⁵/cm².

The electron beams may be irradiated to the entire surface of the silicon single-crystal substrate.

Furthermore, it is sufficient to irradiate the electron beams to the silicon single-crystal substrate, and this electron beam irradiation can be performed after the formation step of the nitride semiconductor film described below. When a plurality of nitride semiconductor layers is formed as the nitride semiconductor film, the electron beam irradiation may be performed during the formation of a plurality of nitride semiconductor layers. When electron beam irradiation is performed after the nitride semiconductor film is formed, it can be performed before or after the device formation. For example, the wafer-shaped substrate, in which the device is formed on the nitride semiconductor film on a silicon single-crystal substrate before dicing, can be irradiated with electron beams at the irradiation dose above-described.

Additionally, the electron beam irradiation can be performed before or after the formation of the nitride semiconductor film (or formation of the device), in particular, can be performed from a rear side (silicon single-crystal substrate side).

Thus, by irradiating electron beams of the above-predetermined irradiation dose to reduce the dopant and/or the carrier (making the silicon single-crystal substrate highly resistive), it is considered that when high-frequency is applied, the carriers that follow the high-frequency are eliminated, and then the harmonic is reduced.

Then, a nitride semiconductor is formed by epitaxial growth. The nitride semiconductor film formed is not particularly limited. When at least one layer of the nitride semiconductor layer is included, the layer may be a single layer or a plurality of layers. For example, when a plurality of nitride semiconductor layers is formed as the nitride semiconductor film, the intermediate layer is formed first as shown in FIG. 1.

As the intermediate layer, such as an AlN layer of 150 nm thickness on the silicon single-crystal substrate can be formed, and on top of that, such as an AlGaN layer of 160 nm thickness can be formed, and on further top of that, such as a superlattice layer, in which such as 70 pairs of the GaN and AlN layers are stacked alternately, can be formed.

Then a device layer is formed. As the device layer, such as a GaN layer of 800 nm thickness can be formed, and on top of that, such as an AlGaN layer of 25nm thickness can be formed, further on top of that, such as a GaN layer of 3 nm can be formed.

Consequently, by the producing method of the present invention, the nitride semiconductor wafer produced by irradiating electron beams of the above-predetermined irradiation dose has an improved loss and second harmonic characteristic, then the degradation of the characteristic can be suppressed. In particular, a high-frequency device produced from such nitride semiconductor wafer has the improved loss and can suppress the degradation of the second harmonic characteristic.

Moreover, in order to measure and evaluate harmonic characteristics, an Al electrode of CPW (Co-Planar Waveguide) can be formed as shown in FIG. 2. The nitride semiconductor wafer produced by forming the nitride semiconductor film using epitaxial growth is taken out from a film-forming apparatus, an insulating film is formed on the wafer, and then the Al electrode of CPW is formed on this insulating film by photolithography.

CPW has a structure in which metal electrodes are arranged in parallel with gaps between them, and a linear central metal electrode is formed in parallel with these metal electrodes in the center of the gap. In one example shown in Figure 2, the structure has a linear gap in the center of the metal electrodes, and a linear electrode is formed in the center of this gap without touching the outer metal electrodes.

CPW, with this structure, transmits an electromagnetic wave through an electric field and a magnetic field. The electric field has the direction from the central metal electrode to the metal electrodes on the left and right sides and inside the semiconductor substrate, while the magnetic field has the direction surrounding the central metal electrode inside the semiconductor substrate. Once CPW is formed on the wafer, the harmonic characteristics (Harmonic Distortion: HD) can be measured.

### EXAMPLE

Hereinafter, the present invention will be specifically described with reference to Examples. However, the present invention is not limited thereto.

### (Example and Comparative Example)

Three types of silicon single-crystal substrates having different resistivity (8 mQcm, 8 Qcm, 5531 Qcm) were prepared. As an intermediate layer on three types of silicon single-crystal substrates above-described, an AlN layer of 150 nm thickness was formed, and on top of that, an AlGaN layer of 160 nm thickness was formed, and further top of that, a superlattice layer composed of 70 pairs of GaN and AlN layers stacked alternately was formed. Then, as a device layer, a GaN layer of 800 nm thickness was formed, and on top of that, an AlGaN layer of 25 nm thickness was formed, and further on top of that, a GaN layer of 3 nm thickness was formed (see FIG. 1) .

A nitride semiconductor wafer, which had a nitride semiconductor film formed by epitaxial growth, was taken out from a growth apparatus, then an insulating film was formed on the wafer. Then an electrode (Al) of CPW (line length: 2199 µm) was formed using a photolithography process as shown in FIG. 2.

Subsequently, a second harmonic characteristic (2HD) of each device in the nitride semiconductor wafer was measured before an electron beam irradiation (no irradiation).

After this measurement, the electron beam irradiation was performed on the nitride semiconductor wafer. The electron beam irradiation was performed by NHV Corporation 3000kV machine of Nissin Electric Co., Ltd. with different dose amounts of 2 MeV, 5×10¹¹/cm², 5×10¹²/cm², 1×10¹⁴/cm², 1×10¹⁵/cm².

Then, the second harmonic characteristic (2HD) of each device of the nitride semiconductor wafer after the electron beam irradiation was measured.

In this case, the three cases of no irradiation, 5×10¹¹/cm², and 5×10¹²/cm² were Comparative Examples, while the two cases of 1×10¹⁴/cm², and 1×10¹⁵/cm² were Examples.

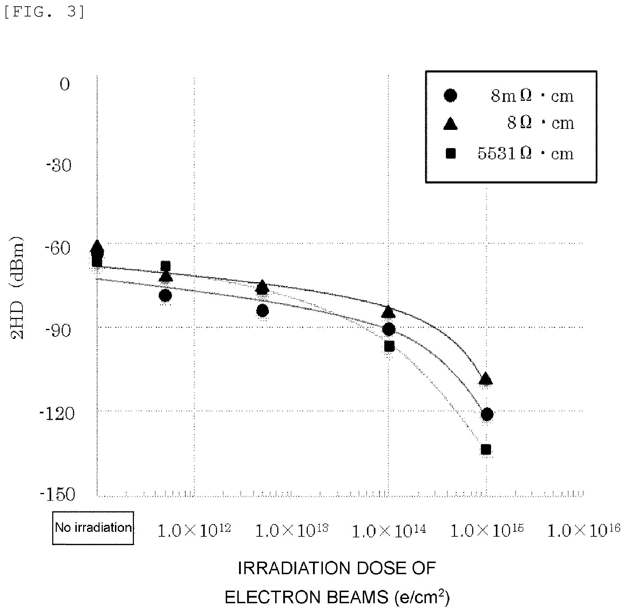

The results of the measurements are shown in FIG. 3. FIG. 3 is a graph showing second harmonic characteristics of substrates with the different resistivities. The larger the negative value on the vertical axis in the graph, the better the second harmonic characteristic. Although the leftmost position on the horizontal axis is at 1×10¹¹/cm², the plot itself shows the measured values in the case of no irradiation (i.e., irradiation dose is 0/cm²).

When the second harmonic characteristics at respective irradiation doses were compared for the above respective types (resistivities), as shown in FIG. 3, the results show that the two cases of 1×10¹⁴/cm², and 1×10¹⁵/cm² (Examples) are more improved than the three cases of no irradiation, 5×10¹¹/cm², and 5×10¹²/cm² (Comparative Examples) in any type.

For example, in the case of 8 Ωcm, the second harmonic loss of the nitride semiconductor wafer irradiated with electron beams of 1×10¹⁴/cm² showed a 20 dBm improvement compared to a case without irradiation. Furthermore, it was found that the second harmonic loss was improved by about 25 dBm when electron beams were irradiated at 1×10¹⁵/cm² than the case of 1×10¹⁴/cm². That is, an improvement of about 45 dBm was observed when compared to the case without irradiation.

Also in the case of 8 mΩcm and 5531 Ωcm, the same or more improvement was observed.

As shown in the graph, the second harmonic did not change significantly from no irradiation (irradiation dose of 0/cm²) to an irradiation dose of about 5×10¹²/cm², however, the graph shows that with 1×10¹⁴/cm² as a boundary, the second harmonic improves substantially. As can be seen from the curve in the graph, the second harmonic was further improved as the irradiation dose increased to 3×10¹⁴/cm² or more, and even 1×10¹⁵/cm² or more. Although the second harmonic was significantly improved at irradiation dose of 1×10¹⁶/cm² and more, the degree of improvement was considered sufficient at an irradiation dose of about 1×10¹⁶/cm² when efficiency was considered.

Additionally, the loss due to the substrate was also investigated. In this case, this loss is defined as a power loss due to leakage current caused by 2DEG (two-dimensional electron gas) in the SLs part of the intermediate layer (buffer layer) and P-channelization due to Al diffusion from the AlN layer to the silicon single-crystal substrate.

Losses at respective irradiation doses were compared for the above respective types (resistivities). As in the case of the second harmonic characteristics, the results showed that the two cases of 1×10¹⁴/cm², 1×10¹⁵/cm² (Examples) were more improved than the three cases of no irradiation, 5×10¹¹/cm², 5×10¹²/cm² (Comparative Examples).

For example, in the type of 8 Qcm, the loss was about -60 dBm/mm between no irradiation and about 5×10¹²/cm², however, the loss was -80 dBm/mm in the case of 1×10¹⁴/cm², which showed an improvement. With 1×10¹⁴/cm² as a boundary, the even greater improvement was confirmed in the case of 1×10¹⁴/cm² or more.

It should be noted that the present invention is not limited to the above-described embodiments. The embodiments are just examples, and any examples that have substantially the same features and demonstrate the same functions and effects as those in the technical concept disclosed in claims of the present invention are included in the technical scope of the present invention.

## Claims

1. A method for producing a nitride semiconductor wafer by forming a nitride semiconductor film on a silicon single-crystal substrate, comprising the steps of:
forming the nitride semiconductor film on the silicon single-crystal substrate; and
irradiating the silicon single-crystal substrate with electron beams with an irradiation dose of 1×10¹⁴/cm² or more.

2. The method for producing a nitride semiconductor wafer according to claim 1, wherein
the irradiation dose of the electron beams to be irradiated is 3×10¹⁴/cm² or more and 1×10¹⁶/cm² or less in the step of irradiating the electron beams.

3. The method for producing a nitride semiconductor wafer according to claim 1 or 2, wherein
the step of irradiating the electron beams is performed before the step of forming the nitride semiconductor film.

4. The method for producing a nitride semiconductor wafer according to claim 1 or 2, wherein
the step of irradiating the electron beams is performed after the step of forming the nitride semiconductor film.

5. The method for producing a nitride semiconductor wafer according to claim 4, wherein
a device is further formed in the nitride semiconductor film after the step of forming the nitride semiconductor film, and
the step of irradiating the electron beams is then performed.
